# EUROPEAN PATENT APPLICATION

(11) **EP 4 465 349 A1**
(43) Date of publication of application: **20.11.2024**
(21) Application number: 24751625.5
(22) Date of filing: 01.02.2024
(51) Int. Cl.: H01L 23/367, H01L 23/31, H01L 23/552, H01L 23/58, H01L 25/18

(54) **POWER CONVERTER, PACKAGING STRUCTURE AND HEAT DISSIPATION STRUCTURE**

(30) Priority: 09.03.2023 CN 202310252427; 10.10.2023 CN 202311303959
(71) Applicant: Huawei Digital Power Technologies Co., Ltd., Shenzhen, Guangdong 518043 (CN)
(72) Inventor: ZHANG, Xingzhong, Shenzhen, Guangdong 518043 (CN); CHEN, Shanwu, Shenzhen, Guangdong 518043 (CN); CHENG, Jiebin, Shenzhen, Guangdong 518043 (CN); WU, Baoshan, Shenzhen, Guangdong 518043 (CN); SONG, Weiping, Shenzhen, Guangdong 518043 (CN)
(74) Representative: Gill Jennings & Every LLP
(86) International application number: PCT/CN2024/075345
(87) International publication number: WO 2024/183515

(57) **Abstract**

The present invention provides a power converter, a package structure, and a heat dissipation structure. The power converter includes a heat dissipation structure and a housing. The heat dissipation structure includes the package structure and a PCB. The package structure includes a first substrate, a second substrate, a package body, pins, and a first die. The package structure is connected to the PCB through the pins. The first substrate, the second substrate, and the die are packaged in the package body. The first substrate includes a first routing layer, a first insulation layer, and a first metal layer that are sequentially stacked, and the second substrate includes a second routing layer, a second insulation layer, and a second metal layer that are sequentially stacked. The first metal layer is mechanically and electrically connected to a first part of the second routing layer, and at least one of the first metal layer and the first part of the second routing layer is connected to a quiescent point. At least one first die is disposed on a surface that is of the first routing layer and that is away from the first metal layer, and a contact point between the die and the first routing layer is a moving point. The package structure has a simple structure, low costs, and good heat dissipation, safety regulation, and electromagnetic shielding functions.

## Description

This application claims priorities to Chinese Patent Application No. 202310252427.X, filed with the China National Intellectual Property Administration on March 9, 2023 and entitled "POWER CONVERTER, PACKAGE STRUCTURE, AND HEAT DISSIPATION STRUCTURE"; and to Chinese Patent Application No.202311303959.8, filed with the China National Intellectual Property Administration on October 10, 2023 and entitled "POWER CONVERTER, PACKAGE STRUCTURE, AND HEAT DISSIPATION STRUCTURE", both of which are incorporated herein by reference in their entireties.

### TECHNICAL FIELD

This application relates to the field of electronic products, and in particular, to a power converter, a package structure, and a heat dissipation structure.

### BACKGROUND

In recent years, designs of photovoltaic optimizers, power modules, and other power converters gradually evolve in a direction of miniaturization and high power density. For a photovoltaic optimizer product, if a housing of the photovoltaic optimizer product is grounded, complex routing is generally included. Consequently, costs are high, and maintenance is difficult. Therefore, a ground wire is usually omitted in the industry. However, if a photovoltaic optimizer is not grounded, large dv/dt and di/dt are generated in a process in which a power device inside the photovoltaic optimizer is turned on and turned off. Consequently, electromagnetic noise is enhanced, an electromagnetic compatibility (Electromagnetic Compatibility, EMC) of the photovoltaic optimizer is reduced, and reliability is reduced. To resolve an EMC problem, a metal shield layer usually needs to be added between a moving point of a switch of the power device inside the photovoltaic optimizer and a metal housing of the photovoltaic optimizer. However, disposition of the metal shield layer increases inter-layer thermal resistance. This is not conducive to heat dissipation of a power device such as a MOS transistor; and in addition, costs and a volume of the photovoltaic optimizer are increased. Therefore, how to adopt an effective solution to resolve the EMC problem of the photovoltaic optimizer and let clean energy enter thousands of households is of great significance.

### SUMMARY

Embodiments of this application provide a power converter, a package structure, and a heat dissipation structure. The power converter has a good electromagnetic shielding function. Therefore, a metal shield layer for implementing noise backflow does not need to be additionally disposed on the power converter, so that a structure of the power converter is simplified, and material costs are reduced.

According to a first aspect, an embodiment of this application provides a power converter. The power converter includes a heat dissipation structure and a housing, and the heat dissipation structure is located in accommodation space enclosed by the housing. The heat dissipation structure includes a package structure and a printed circuit board (Printed circuit board, PCB). The package structure includes a first substrate, a second substrate, a package body, a plurality of pins, and at least one first die, and the package structure is connected to the PCB through the plurality of pins. The first substrate, the second substrate, and the die are plastically packaged in the package body. Specifically, the first substrate includes a first routing layer, a first insulation layer, and a first metal layer that are sequentially stacked, and the second substrate includes a second routing layer, a second insulation layer, and a second metal layer that are sequentially stacked. The first metal layer is disposed on a surface that is of the second routing layer and that is away from the second metal layer. The first metal layer is electrically connected to the second routing layer, and at least one of the first metal layer and the second routing layer is electrically connected to a quiescent point. The at least one first die is disposed on a surface that is of the first routing layer and that is away from the first metal layer, and a contact point between the at least one first die and the first routing layer is a moving point. With this deposition, the first die can be flexibly disposed in any area of the first routing layer, so that an electromagnetic shielding function of the power converter is improved.

In a possible implementation, all the plurality of pins are fastened to the first routing layer; or all the plurality of pins are fastened to the second routing layer; or a part of the plurality of pins are fastened to the first routing layer, and the other part of the plurality of pins are fastened to the second routing layer. A pin that is of the plurality of pins and that is electrically connected to the first metal layer is electrically connected to the quiescent point. With this deposition, an outgoing wire of the package structure can be better adapted, to facilitate processing.

In a possible implementation, the second routing layer is divided into a first part and a second part. The first part and the second part are disposed at an interval, and the first part is in contact with a surface that is of the first metal layer and that is away from the first routing layer. At least one second die is disposed on a surface that is of the second part and that is away from the second metal, and a contact point between the at least one second die and the second part is a quiescent point.

For example, when the package structure includes two dies, one first die is disposed on the first routing layer, and one second die is disposed on the second part of the second routing layer. A position of a die is mainly related to an amount of heat generated by the die, a structure of the die, and a connection relationship of the die in a circuit.

Specifically, because the first substrate is fastened to the second substrate through the first metal layer and the first part of the second routing layer, and heat dissipation of the die points from the routing layer connected to the second metal layer, in a working state, the first die faces greater interface thermal resistance in a heat dissipation process, and heat dissipation efficiency is lower. To better implement heat dissipation, in this application, a die that generates a large amount of heat is disposed on the second part of the second routing layer, and a die that generates a small amount of heat is disposed on the first routing layer.

In addition, the die described in this application is an unpackaged power semiconductor chip. Based on the structure of the die, a surface that is of the die and that is connected to the first routing layer or the second routing layer is generally a drain, and the other surface opposite to this surface is generally a source. Based on a difference of power conversion circuits in the package structure, a die whose drain is a moving point may be disposed on the first routing layer, and a die whose drain is a quiescent point may be disposed on the second part of the second routing layer. Because the drain of the die disposed on the second part of the second routing layer is the quiescent point, the second part that is of the second routing layer and that is electrically interconnected to the die is also a quiescent point. In this way, a capacitor formed by the second part of the second routing layer and a metal housing or another metal layer of the power converter basically is not charged or discharged because the die is turned on or turned off, to avoid generation of electromagnetic noise. Because the drain of the die disposed on the first routing layer is the moving point, the first metal layer or the first part of the second routing layer needs to be connected to the quiescent point, to implement effect of shielding noise backflow. The quiescent point may be located inside the package structure, or may be located outside the package structure.

In actual application, a quantity of dies in the package structure may not be limited to two. When there are more than two dies, based on a same principle, a die that generates a large amount of heat may be disposed on the second part of the second routing layer, and a die that generates a small amount of heat may be disposed on the first routing layer. A die whose surface connected to the routing layer is a moving point is disposed on the first routing layer, and a die whose surface connected to the routing layer is a quiescent point is disposed on the second part of the second routing layer.

In a possible implementation, the pins are fastened to a side surface of the package structure. The side surface extends in a stacking direction of the first substrate and the second substrate. The pin that is of the plurality of pins and that is electrically connected to the first metal layer is electrically connected to a quiescent point of the PCB. That is, when the second routing layer is a whole, potentials of the first metal layer and the second routing layer are the same as that of the quiescent point on the PCB. When the second routing layer is divided into at least two parts, potentials of the first metal layer and the first part of the second routing layer are the same as that of the quiescent point on the PCB. With this setting, the potentials of the first metal layer and the second routing layer, or the potentials of the first metal layer and the first part of the second routing layer may basically remain unchanged relative to the ground. Therefore, no electromagnetic noise is generated in a process in which the die disposed on the first routing layer is turned on and turned off, so that electromagnetic shielding effect of the power converter is further improved.

In a possible implementation, in the stacking direction of the first substrate and the second substrate, a projection of the first substrate is located within a contour range of a projection of the second substrate. In other words, the first substrate is smaller than the second substrate. With this disposition, positions of the dies and the substrates may be flexibly adjusted based on connection relationships of the dies in the circuit, to better implement the electromagnetic shielding function of the photovoltaic optimizer. At the same time, the second part of the second routing layer is also connected to the quiescent point. The quiescent point may be an internal quiescent point of the package structure, or may be an external quiescent point. As described above, when the second part of the second routing layer is connected to the quiescent point, in a process in which the second part disposed on the second routing layer is turned on or turned off, an obvious charging/discharging phenomenon does not occur on the capacitor formed by the second part of the second routing layer and the metal housing or another metal layer of the photovoltaic optimizer. In other words, no electromagnetic noise is generated.

In a possible implementation, for the second substrate, in the stacking direction of the first substrate and the second substrate, a projection of the second routing layer and a projection of the second metal layer are located within a contour range of a projection of the second insulation layer. In other words, there are distances by which edges of the second routing layer and the second metal layer are retracted relative to an edge of the second insulation layer. In actual application, the distances by which the second routing layer and the second metal layer are retracted relative to the second insulation layer may be flexibly adjusted, to meet a safety regulation requirement of the package structure for basic insulation, enhanced insulation, functional insulation, or the like.

In a possible implementation, for the first substrate, in the stacking direction of the first substrate and the second substrate, a projection of the first routing layer and a projection of the first metal layer coincide with a projection of the first insulation layer; or a projection of the first routing layer and a projection of the first metal layer are located within a contour range of a projection of the first insulation layer. When the projection of the first insulation layer coincides with the projection of the first routing layer and the projection of the first metal layer, processing of the first substrate can be more convenient. When the projection of the first routing layer and the projection of the first metal layer are located within the contour range of the projection of the first insulation layer, better insulation effect can be achieved.

In a possible implementation, an amount of heat generated by the first die disposed on the first routing layer is less than an amount of heat generated by the second die disposed on the second part of the second routing layer. As described above, this deposition can better adapt to heat emission statuses of different dies, so that a die that generates a large amount of heat has small heat dissipation thermal resistance, to enhance heat dissipation efficiency of the package structure and improve working efficiency and stability of the dies in the package structure.

In a possible implementation, a thickness of the package structure in a vertical direction of the first part of the second routing layer is greater than a thickness of the package structure in a vertical direction of the second part of the second routing layer. With this deposition, a thickness of the package body in the vertical direction of the first part of the second routing layer may be reduced. Therefore, when thermal runaway occurs on the die disposed on the second part of the second routing layer, energy is more likely to be released from a bottom surface of the package structure, to protect the second insulation layer, prevent accidents such as electric leakage of the power converter, and improve safety of the power converter. It should be noted that, for the package structure, a surface that is of the package structure and that is close to the PCB is the bottom surface, and one surface opposite to the bottom surface is a top surface.

In a possible implementation, an insulation fence is further disposed on the side surface of the package structure, and the insulation fence is located between the pins and the top surface of the package structure. The insulation fence is disposed, so that a creepage distance can be effectively increased, and the safety and reliability of the package structure can be improved.

In a possible implementation, one end of the top surface of the package structure is connected to an edge of the second metal layer, and the other end of the top surface of the package structure is connected to the side surface of the package structure. In other words, the top surface of the package structure is a hollow-out structure, the second metal layer is embedded in a hollow-out region, and the edge of the second metal layer is connected to an edge of the hollow-out structure. With this deposition, inter-layer thermal resistance can be reduced, and the heat dissipation efficiency of the package structure can be improved.

In a possible implementation, the package structure is connected to the housing. With this deposition, there is no medium with a low thermal conductivity coefficient, such as air, between the package structure and the housing, so that the heat dissipation efficiency of the power converter is better improved.

According to a second aspect, an embodiment of this application further provides a package structure. The package structure includes the package structure according to any implementation of the first aspect.

According to a third aspect, this application further provides a heat dissipation structure. The heat dissipation structure includes the heat dissipation structure according to any implementation of the first aspect.

In conclusion, in this application, a power conversion circuit of a power converter is disposed in one package structure, and dies are respectively disposed on a first routing layer and a second part of a second routing layer based on positions of different dies in a circuit, amounts of heat generated by the dies, and structures of the dies, so that three functions of heat dissipation, safety regulation, and electromagnetic shielding are implemented. Further, a first metal layer or a first part of the second routing layer is connected to a quiescent point on a PCB through pins, so that electromagnetic shielding effect of the power converter can be further enhanced. In addition, a bottom surface of the package structure is set to a structure with an uneven thickness, so that when thermal runaway occurs on the dies, energy can be more likely to be released from the bottom surface of the package structure without damaging a second insulation layer, to achieve better safety regulation effect. In addition, an insulation fence is disposed on a side surface of the package structure, so that a creepage distance can be increased, to improve the safety regulation effect of the package structure. Finally, the package structure has a simple structure and low material costs, so that the power converter can achieve good electromagnetic shielding effect without additionally mounting a metal shield layer, and development requirements of miniaturization and high power of the power converter are met.

### BRIEF DESCRIPTION OF DRAWINGS

FIG. 1a is a diagram of a cross-sectional structure of a package structure in a photovoltaic optimizer;
FIG. 1b is a diagram of a cross-sectional structure of another package structure in a photovoltaic optimizer;
FIG. 2 is a circuit topology schematic of a buck circuit and a bypass diode of an optimizer;
FIG. 3a is a cross-sectional diagram of a package structure according to an embodiment of this application;
FIG. 3b is a cross-sectional diagram of a package structure according to an embodiment of this application;
FIG. 3c is a cross-sectional diagram of a package structure according to an embodiment of this application;
FIG. 3d is a cross-sectional diagram of a package structure according to an embodiment of this application;
FIG. 3e is a cross-sectional diagram of a package structure according to an embodiment of this application;
FIG. 3f is a cross-sectional diagram of a package structure according to an embodiment of this application;
FIG. 3g is a cross-sectional diagram of a package structure according to an embodiment of this application;
FIG. 3h is a cross-sectional diagram of a package structure according to an embodiment of this application;
FIG. 4 is a three-dimensional diagram of a package structure according to an embodiment of this application;
FIG. 5a is a cross-sectional diagram of a power converter according to an embodiment of this application;
FIG. 5b is a cross-sectional diagram of a power converter according to an embodiment of this application;
FIG. 5c is a cross-sectional diagram of a power converter according to an embodiment of this application;
FIG. 5d is a cross-sectional diagram of a power converter according to an embodiment of this application;
FIG. 5e is a cross-sectional diagram of a power converter according to an embodiment of this application;
FIG. 5f is a cross-sectional diagram of a power converter according to an embodiment of this application; and
FIG. 5g is a cross-sectional diagram of a power converter according to an embodiment of this application.

### DESCRIPTION OF EMBODIMENTS

A photovoltaic optimizer can perform maximum power point tracking (Maximum Power Point Tracking, MPPT) on a single photovoltaic module in real time by using a unique software algorithm and a circuit topology, to resolve a problem that an energy yield of a photovoltaic system decreases due to shielding and orientation differences of photovoltaic modules, achieve a maximum power output of the single photovoltaic module, and improve power generation efficiency of the photovoltaic system.

With increasingly high requirements for high efficiency and high reliability of photovoltaic optimizers in the industry, an EMC problem of the photovoltaic optimizers attracts more attention. However, most existing photovoltaic optimizer products use highly integrated package structures, and these package structures usually have no self-shielding function. Therefore, in the industry, an additional metal shield layer is generally disposed between the package structure and a metal housing of the photovoltaic optimizer to implement electromagnetic shielding effect. Consequently, costs increase, interface thermal resistance increases, and heat dissipation efficiency is low.

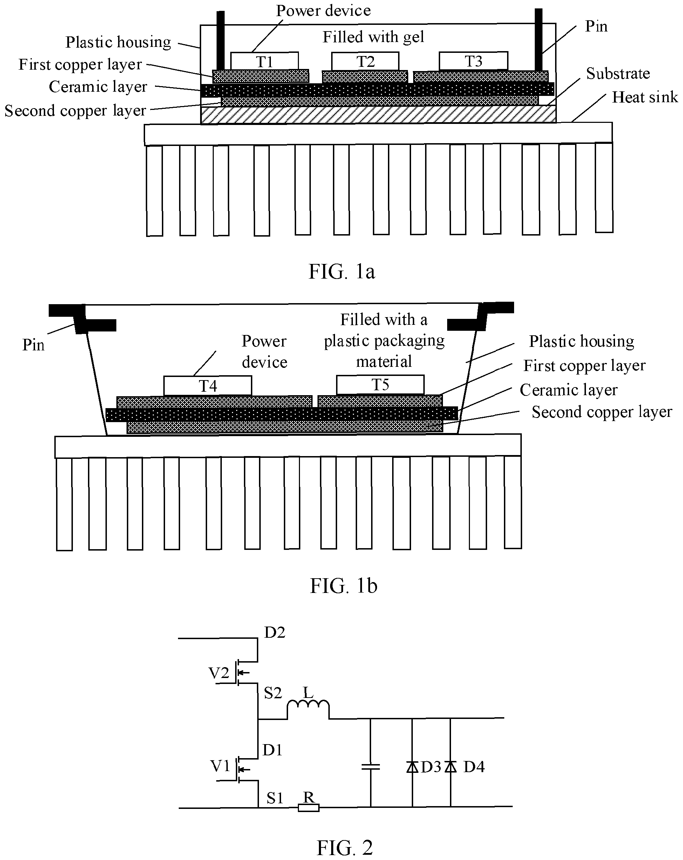

FIG. 1a is a diagram of a cross-sectional structure of a package structure used in a high-power photovoltaic optimizer. T1, T2, and T3 respectively represent dies of three switching transistors, and the switching transistors may be metal-oxide-semiconductor field-effect transistors (Metal-Oxide-Semiconductor Field-Effect Transistors, MOSFETs), insulated gate bipolar transistors (Insulated Gate Bipolar Transistors, IGBTs), or the like. A die is a chip of a power device that has been tested but has not been packaged. The die is likely to be affected by a temperature, impurities, and a physical force of an external environment. Therefore, the die needs to be sealed in enclosed space, and a corresponding pin is led out, so that the die can be used as a basic component. A direct bonding copper ceramic substrate (Direct Bonding Copper, DBC) includes a first copper layer, a ceramic layer, and a second copper layer that are sequentially stacked. T1, T2, and T3 are fastened on the first copper layer, and are electrically connected through wires. In addition, the first copper layer is further connected to pins, so that T1, T2, and T3 are electrically interconnected to an external control device. The first copper layer and the second copper layer are respectively attached to two surfaces of a ceramic sheet. The ceramic sheet has excellent thermal conductivity performance and high insulation, and can have functions of supporting T1, T2, and T3, and safety regulation insulation. The second copper layer may facilitate fastening of the DBC and a substrate through welding or the like. T1, T2, T3, the DBC, and the substrate are disposed in space enclosed by a plastic housing, and gaps between the plastic housing and T1, T2, T3, the DBC, and the substrate are filled with thermally conductive gel, to achieve functions of buffering and heat dissipation. Further, the substrate may be further connected to a heat sink having a heat dissipation protrusion or a heat dissipation fin by using a material such as thermally conductive silicone grease or gel, to improve a heat dissipation capability of the package structure. The package structure may meet a basic insulation function, but does not meet enhanced insulation. Therefore, safety regulation effect is limited. In addition, the package structure does not have a dedicated shielding function.

FIG. 1b is a diagram of a cross-sectional structure of a package structure used in a lowpower photovoltaic optimizer. T4 and T5 are the same as T1, T2, and T3 shown in FIG. 1a, and are both dies of a power device. A main difference between the structure and the structure shown in FIG. 1a lies in that a second copper layer of a DBC in the structure is directly connected to a heat sink by using thermally conductive silicone grease or gel. Therefore, a substrate between the second copper layer and a heat sink is omitted. In addition, to meet a safety regulation insulation requirement, a material with which gaps between a plastic housing and T4, T5, and the DBC are filled is a plastic packaging material. Consequently, an overall thickness of the module is thick. Although the plastic packaging material has higher mechanical strength and can better protect T4 and T5 from external impact, when thermal runaway occurs in T4 and T5, because the mechanical strength of the plastic packaging material is high, energy is more likely to be released from the DBC. Consequently, cracking occurs on a ceramic layer in the DBC. This seriously affects safety regulation insulation effect of the package structure. In addition, the structure does not have a dedicated shielding function, either.

Based on the foregoing problem, embodiments of this application provide a photovoltaic optimizer, a package structure, and a heat dissipation structure. A preparation process of the photovoltaic optimizer is simple, electromagnetic shielding effect is good, and no electromagnetic shield layer needs to be additionally disposed.

FIG. 2 is a topology schematic of a power conversion circuit in a photovoltaic optimizer. A source electrode S 1 of a first switching transistor V1 is connected to a negative direct current bus; and a voltage of the source S1 of the first switching transistor V1 is restricted by a voltage of the negative direct current bus, and may be stabilized within a specific range. Therefore, a connection part between the source S 1 of the first switching transistor V1 and the negative direct current bus is a quiescent point. The quiescent point is a point at which a potential does not change abruptly relative to the ground. Similarly, a drain D2 of a second switching transistor V2 is connected to a positive direct current bus; and a voltage of the drain D2 of the second switching transistor V2 is restricted by a voltage of the direct current bus, and may be stabilized within a specific range. Therefore, a connection part between the drain D2 of the second switching transistor V2 and the positive direct current bus is a quiescent point. In addition, a source S2 of the second switching transistor V2 is connected to a drain D1 of the first switching transistor V1. In a process in which the second switching transistor V2 and the first switching transistor V1 are conducted and cut off, a voltage between the source S2 of the second switching transistor V2 and the drain D1 of the first switching transistor V1 fluctuates. Therefore, a circuit connection part between the source S2 of the second switching transistor V2 and the drain D1 of the first switching transistor V1 is a moving point. The moving point is a point at which a potential changes abruptly relative to the ground, and the moving point is a main reason of electromagnetic radiation.

It should be noted that the circuit topology schematic shown in FIG. 2 is merely an example. In actual application, the circuit may be further extended to a boost circuit, a buck-boost circuit, a Cuk circuit, or the like, and a circuit topology of a package module may also be a fullbridge circuit. This is not limited in this application.

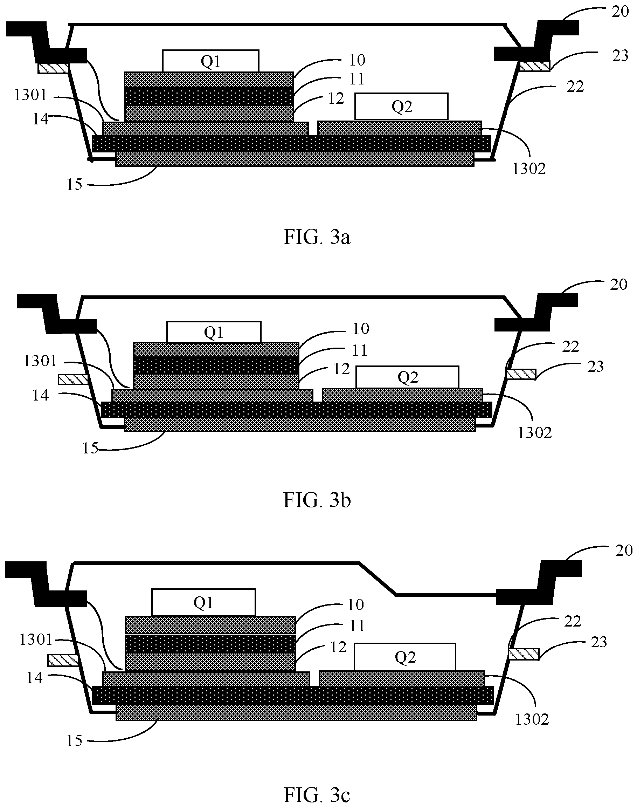

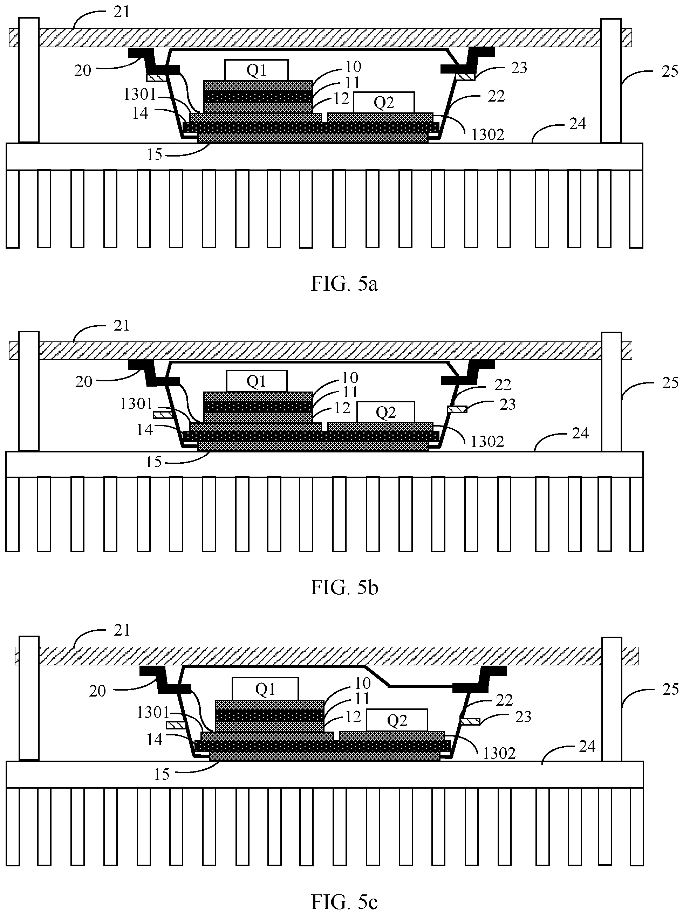

The following describes in detail a package structure, a heat dissipation structure, and a photovoltaic optimizer provided in this application with reference to FIG. 3a to FIG. 3h and FIG. 5a to FIG. 5g, and specifically describes technical effect generated by the package structure, the heat dissipation structure, and the photovoltaic optimizer.

FIG. 3a is a cross-sectional diagram of a package structure according to this application. The package structure includes a first substrate, a second substrate, a package body 22, pins 20, and dies. The first substrate includes a first routing layer 10, a first insulation layer 11, and a first metal layer 12 that are sequentially stacked, and the second substrate includes a second routing layer, a second insulation layer 14, and a second metal layer 15 that are sequentially stacked. The second routing layer includes a first part 1301 and a second part 1302, and the first part 1301 of the second routing layer and the second part 1302 of the second routing layer are disposed at an interval. The first metal layer 12 is connected to a surface that is of the first part 1301 of the second routing layer and that is away from the second metal layer 15, and the first metal layer 12 is electrically interconnected to the first part 1301 of the second routing layer. For example, the first metal layer 12 is welded to the first part 1301 of the second routing layer.

Further, the first routing layer 10, the first metal layer 12, the second routing layer, and the second metal layer 15 may be made of a material with high conductivity, such as copper, aluminum, silver, or copper-aluminum alloy. The first insulation layer 11 and the second insulation layer 14 may be made of a material with high thermal conductivity, high mechanical strength, and a low expansion coefficient, such as ceramic or a polymer insulation medium, for example, aluminum oxide Al₂O₃, aluminum nitride AlN, or silicon nitride Si₃N₄. In addition, the first routing layer 10 and the first metal layer 12 may be laid or plated on two opposite surfaces of the first insulation layer 11. Similarly, the second routing layer and the second metal layer 15 may be laid or plated on two opposite surfaces of the second insulation layer 14. This is not limited in this application.

In addition, in this application, a power conversion circuit of the photovoltaic optimizer is directly disposed in one package structure, that is, in this application, the power conversion circuit shown in FIG. 2 is directly disposed in the package structure. Therefore, the first switching transistor V1 shown in FIG. 2 corresponds to a die Q1 in FIG. 3a, and the die Q1 is disposed on the first routing layer 10. The second switching transistor V2 shown in FIG. 2 corresponds to a die Q2 in FIG. 3a, and the die Q2 is disposed on the second part 1302 of the second routing layer. In addition, bypass diodes D3 and D4 and the like shown in FIG. 2 may also be disposed on the second part 1302 of the second routing layer. The first routing layer 10 may be electrically interconnected to a source of the die Q2 through a bonding wire (bonding wire) or clip. This is not shown in FIG. 3a.

Because both the die Q1 and the die Q2 are likely to be affected by an external temperature, impurities, and a physical force, the die Q1, the die Q2, the bypass diodes D3 and D4, the first substrate, the second substrate, and the like are all disposed in the package body 22. In addition, remaining space in the package body 22 is filled through plastic packaging or potting, so that the die Q1 and the die Q2 are protected from being affected by an external environment. The plastic packaging is also referred to as hard packaging, and a packaging material is mainly an epoxy molding compound. The epoxy molding compound is usually prepared by using epoxy resin as a matrix and mixing a curing agent, a curing accelerator, a coupling agent, a mold release agent, a filler, a flame retardant, and other additives according to a specific proportion through an appropriate process. The material used for plastic packaging generally has strong mechanical properties and can have a specific mechanical fastening function. However, because a thermal expansion coefficient of the material is different from that of a material such as a metal conductor, thermal fatigue cracking of the material easily occurs. Therefore, in addition to high insulation performance, high thermal conductivity and a low thermal expansion coefficient are also required. Potting is also referred to as soft packaging. A material used for potting is usually an organic filling medium, including epoxy resin, polyurethane, and silicone gel. These organic filling media are poured into functional modules of power electronic devices, and are cured under specific conditions to form an elastic colloidal state. Potting not only can implement functions of moistureproof, dust-proof, and buffering and shockproof for devices and lines in the module, but can also resist the corrosion and impact of the environment on the devices and lines and reduce a failure probability of the devices of the module. Potting has good insulation, shockproof and isolation effect, and can reduce the external adverse impact factors to very low.

As described above, in FIG. 2, the drain D2 of the second switching transistor V2 is connected to the positive direct current bus and is the quiescent point, and the source S1 of the first switching transistor V1 is connected to the negative direct current bus and is also the quiescent point. The source S2 of the second switching transistor V2, the drain D1 of the first switching transistor V1, and the connection part between the source S2 of the second switching transistor V2 and the drain D1 of the first switching transistor V1 are the moving points. Generally, a surface that is of a die and that is connected to a routing layer is a drain, and the other surface opposite to this surface is a source. Therefore, based on structures of the dies, the first routing layer 10 connected to the die Q1 is a moving point, and the second part 1302 that is of the second routing layer and that is connected to the die Q2 is a quiescent point. In other words, in a process in which the die Q1 is turned on and turned off, a charging and discharging capacitor is formed between the first routing layer 10 connected to the die Q1 and the metal housing or another metal layer of the photovoltaic optimizer, to generate electromagnetic noise. However, in a process in which the die Q2 is turned on and turned off, no charging and discharging capacitor is formed between the second part 1302 of the second routing layer connected to the die Q2 and the metal housing or the another metal layer of the photovoltaic optimizer, and no electromagnetic noise is generated.

Therefore, to enable the package structure to have self-shielding effect, in this embodiment of this application, the first metal layer 12 or the first part 1301 of the second routing layer is connected to the quiescent point, so that a double-layer structure formed by the first metal layer 12 and the first part of the second routing layer 13 is an electromagnetic shield layer. The quiescent point may be located inside the package structure or outside the package structure. For example, when the quiescent point is located outside the package structure, the second metal layer 12 or the first part 1301 of the second routing layer may be connected to the external quiescent point through the pin 20.

In an implementation, in a thickness direction of the package structure, a projection of the first substrate is located within a contour range of a projection of the second substrate. In other words, the first substrate is smaller than the second substrate. With this disposition, positions of the die Q1 and the die Q2 may be flexibly adjusted based on a connection relationship between the switching transistors in the circuit, to better implement an electromagnetic shielding function of the package structure. At the same time, the second part 1302 of the second routing layer is also connected to the quiescent point. The quiescent point may be an internal quiescent point of the package structure, or may be an external quiescent point. As described above, when the second part 1302 of the second routing layer is connected to the quiescent point, in a process in which the die Q2 disposed on the second part 1302 of the second routing layer is turned on or turned off, an obvious charging/discharging phenomenon does not occur on a capacitor formed by the second part 1302 of the second routing layer and the metal housing or the another metal layer of the photovoltaic optimizer. In other words, no electromagnetic noise is generated.

In an implementation, for the first substrate, in a thickness direction of the package structure, a projection of the first routing layer 10 and a projection of the first metal layer 12 coincide with a projection of the first insulation layer 11; or a projection of the first routing layer 10 and a projection of the first metal layer 12 are located within a contour range of a projection of the first insulation layer 11. When the projection of the first insulation layer 11 coincides with the projections of the first routing layer 10 and the first metal layer 12, in the first substrate, edges of the layers are aligned. Therefore, processing of the first substrate can be simpler. When the projection of the first routing layer 10 and the projection of the first metal layer 12 are located within the contour range of the projection of the first insulation layer 11, there are distances by which edges of the first routing layer 10 and the first metal layer 12 are retracted relative to an edge of the first insulation layer 11. Therefore, the first substrate can achieve better insulation effect. According to an actual requirement, the distances by which the edges of the first routing layer 10 and the first metal layer 12 re retracted relative to the edge of the first insulation layer 11 may be flexibly controlled, to implement safety regulation effect of basic insulation, functional insulation, and enhanced insulation.

In an implementation, for the second substrate, in the thickness direction of the package structure, a projection of the second routing layer 13 and a projection of the second metal layer 15 are located within a contour range of a projection of the second insulation layer 14. In other words, edges of the second routing layer 13 and the second metal layer 15 are located within an edge of the second insulation layer 14. In actual application, distances by which the second routing layer 13 and the second metal layer 15 are retracted relative to the second insulation layer 14 may be flexibly adjusted, to meet a safety regulation requirement of the package structure for basic insulation, enhanced insulation, functional insulation, or the like.

In an implementation, an insulation fence 23 is further disposed on a side surface of the package structure, and the insulation fence 23 is located between the pins 20 and a top surface of the package structure. Specifically, as shown in FIG. 3a, the insulation fence 23 is in contact with the pins 20. In addition, as shown in FIG. 3b, the insulation fence 23 is not in contact with the pins 20. In other words, specific distances exist between the insulation fence 23 and the pins 20 and between the insulation fence 23 and the top surface of the package structure. The insulation fence 23 is disposed, so that a creepage distance can be effectively increased, and safety and reliability of the package structure can be improved. The creepage distance means a shortest distance that is between two conductive parts and that is measured along an insulation surface. In different use cases, because the insulating material around a conductor is polarized, a charged area in which an insulating material is caused to be charged is presented In an implementation provided in this application, the creepage distance is mainly a distance between a surface that is of the second metal layer 15 and that is away from the second routing layer and the pins 20.

In an implementation, for the two package structures shown in FIG. 3a and FIG. 3b, thicknesses of the two package structures in a vertical direction of the first part 1301 of the second routing layer are the same as thicknesses of the two package structures in a vertical direction of the second part 1302 of the second routing layer. With this setting, processing and molding can be more convenient.

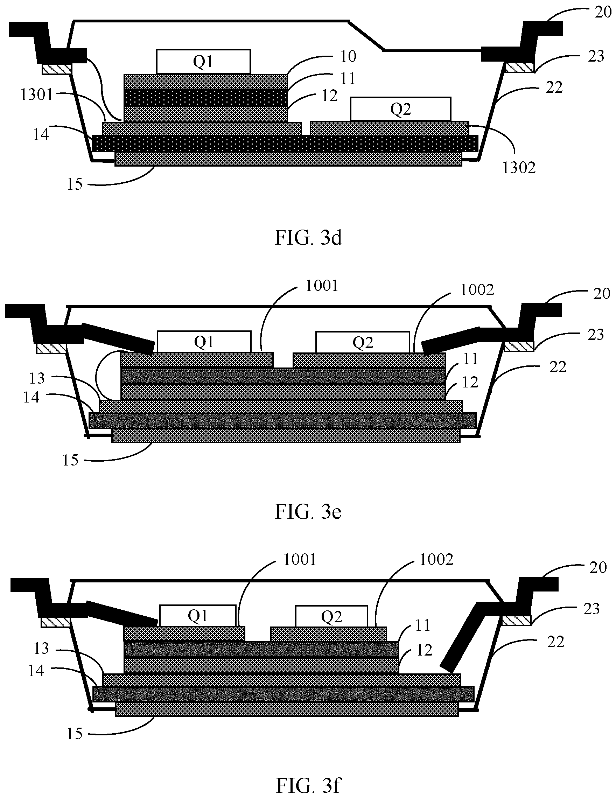

In an implementation, the thickness of the package structure in the vertical direction of the first part 1301 of the second routing layer is greater than the thickness of the package structure in the vertical direction of the second part 1302 of the second routing layer. In other words, a bottom surface of the package structure is an uneven structure. Specifically, refer to FIG. 3c. A difference between FIG. 3c and FIG. 3a lies in that the thickness of the package structure in the vertical direction of the first part 1301 of the second routing layer is greater than the thickness of the package structure in the vertical direction of the second part 1302 of the second routing layer. With this setting, a vertical distance between the die Q2 and the bottom surface of the package structure can be shortened. As described above, an interior of the package body 22 is filled with a medium through plastic packaging, potting, or the like. Especially for a plastic packaging manner, mechanical strength of the medium with which the interior of the package body 22 is filled is high. When thermal runaway occurs on the die Q2, energy generated by the die Q2 needs to be released. If the vertical distance between the die Q2 and the bottom surface of the package structure is long, it means that a large amount of plastic packaging medium is added between the die Q2 and the bottom surface of the package body 22, and the mechanical strength is high. Therefore, energy is more likely to be released from the second substrate with low mechanical strength. Consequently, the second insulation layer 14 in the second substrate is damaged. Therefore, the bottom surface of the package body 22 is set to an uneven structure, so that when thermal runaway occurs on the die Q2, energy can be more likely to be released from the bottom surface of the package structure, to prevent the second insulation layer 14 from being damaged, so that the package structure has better safety and reliability. Based on a same principle, refer to FIG. 3d. A difference between FIG. 3d and FIG. 3b lies only in that the thickness of the package structure in the vertical direction of the first part 1301 of the second routing layer is greater than the thickness of the package structure in the vertical direction of the second part 1302 of the second routing layer. Details are not described herein again.

In addition, a main difference between the two package structures shown in FIG. 3c and FIG. 3d lies in a position difference of the insulation fence 23. To be specific, in FIG. 3c, the insulation fence 23 is located between the pins 20 and the top surface of the package structure and is in contact with the pins 20, and in FIG. 3d, specific distances exist between the insulation fence 23 and the pins 20 and between the insulation fence 23 and the top surface of the package structure.

In a possible implementation, an amount of heat generated by the die disposed on the first routing layer 10 is less than an amount of heat generated by the die disposed on the second part 1302 of the second routing layer. Specifically, in the topology schematic of the power conversion circuit shown in FIG. 2, compared with the second switching transistor V2, the first switching transistor V1 has a shorter turn-on time and a smaller loss. To be specific, the first switching transistor V1 generates less heat in a working state, and the second switching transistor V2 generates more heat in a working state. Therefore, to better implement heat dissipation effect, in the several package structures shown in FIG. 3a to FIG. 3h, the die Q1 is disposed on the first routing layer 10, and the die Q2 is disposed on the second part 1302 of the second routing layer.

Specifically, when the power conversion circuit works, heat dissipation of the die Q1 points from the first routing layer 10 connected to the die Q1 to the second metal layer 15, and heat dissipation of the die Q2 points from the second part 1302 that is of the second routing layer and that is connected to the die Q2 to the second metal layer 15. Therefore, compared with the die Q2, the die Q1 faces greater interface thermal resistance in a heat dissipation process, and heat dissipation efficiency is low. Based on this, the die Q1 that generates a small amount of heat is disposed on the first routing layer, and the die Q2 that generates a large amount of heat is disposed on the second part 1302 of the second routing layer, so that heat dissipation efficiency of the package structure can be better improved.

In actual application, a quantity of dies in the package structure may not be limited to two. In other words, the quantity may be flexibly arranged based on an actual situation of a package circuit. This is not limited in this application. As described above, a die that generates a large amount of heat may be disposed on the second part 1302 of the second routing layer, and a die that generates a small amount of heat may be disposed on the first routing layer 10, to implement better heat dissipation effect.

In a possible implementation, as shown in FIG. 3e to FIG. 3g, in the thickness direction of the package structure, the projection of the first routing layer 10 is also located within a contour range of the projection of the first routing layer 13. However, the first routing layer 13 is a complete copper sheet and is connected to the internal or external quiescent point of the package structure, and both the die Q1 and the die Q2 are placed on the first routing layer 10. The die Q1 is disposed on a first part 1001 of the first routing layer 10, and the die Q2 is disposed on a second part 1002 of the first routing layer 10. With this deposition, a moving point die or a quiescent point die may be flexibly placed in any area of the first routing layer 10. Because the second routing layer 13 is connected to the quiescent point, complete electromagnetic shielding is implemented for the first routing layer 10. In other words, in a process in which the die disposed on the first routing layer 10 is turned on and turned off, no electromagnetic noise is generated, so that electromagnetic shielding effect of the power converter is further improved.

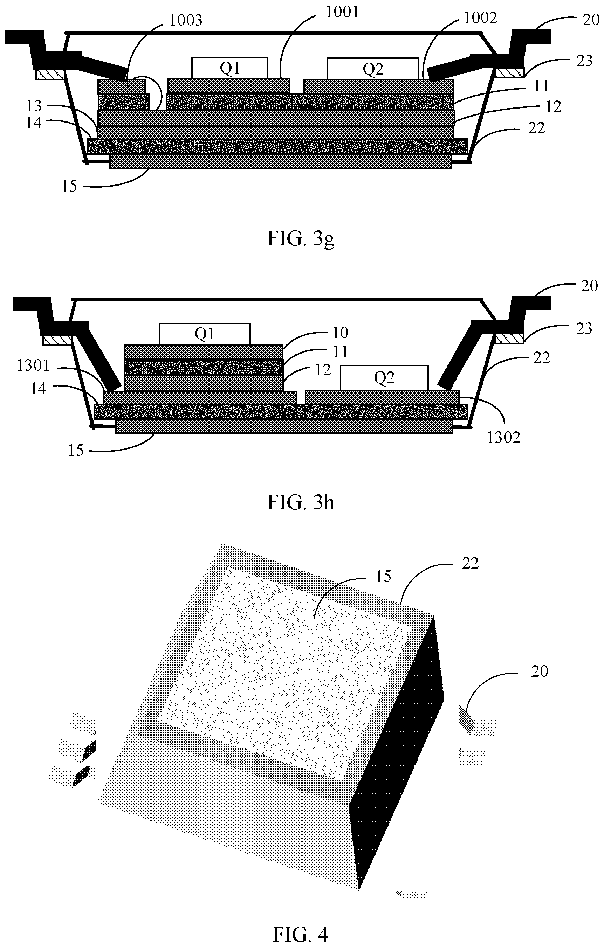

In an actual application, relative areas of the first substrate and the second substrate may be flexibly set. As shown in FIG. 3e, when an area of the first substrate is slightly smaller than that of the second substrate, an electrical connection between the first metal layer 12 and the quiescent point of the first routing layer 10 may be implemented through wire bonding. As shown in FIG. 3f, when the area of the first substrate is smaller than that of the first substrate in FIG. 3e, the pins 20 may be directly disposed on the first routing layer 13, and the first routing layer 13 is connected to the quiescent point of an external PCB through the pins 20. In addition, as shown in FIG. 3g, when the area of the first substrate is equal to an area of the first routing layer 13, the first substrate may be punctured for copper plating or tin spraying, and the first metal layer 12 or the first routing layer 13 is connected to a third part 1003 of the first routing layer 10, where the third part 1003 of the first routing layer 10 is a quiescent point.

In addition, the pins 20 may further be flexibly disposed based on an internal design of the package structure. As shown in FIG. 3e and FIG. 3g, all the pins 20 may be disposed on the first routing layer 10. As shown in FIG. 3f, a part of the pins 20 may be disposed on the first routing layer 10, and the other part of pins 20 are disposed on the first routing layer 13. As shown in FIG. 3h, alternatively, all the pins 20 may be disposed on the first routing layer 13.

In addition, FIG. 4 is a three-dimensional diagram of four package structures shown in FIG. 3. However, for ease of description, the insulation fence 23 is not shown in FIG. 4. With reference to FIG. 4 and FIG. 3, it can be observed that the top surface of the package structure is actually a hollow-out structure. One end of the top surface of the package structure is connected to four side surfaces of the package structure, and the other end of the package structure is connected to an edge of the second metal layer 15. In other words, the second metal layer 15 is embedded in a hollow-out area on the top surface of the package structure. With this deposition, heat dissipation efficiency of the package structure can be enhanced, and reliability of the package structure in a working state can be ensured.

In conclusion, the package structure provided in this application is simple, and is easy to process and form, and in addition to meeting basic requirements such as heat dissipation and safety regulation insulation, the package structure further implements electromagnetic shielding effect, so that there is no need to additionally dispose a metal shield layer between the package structure and the metal housing of the photovoltaic optimizer. This reduces material costs.

Based on this, this application further provides a heat dissipation structure. The heat dissipation structure includes any one of the foregoing package structures and a PCB 21. The package structure is electrically interconnected to a quiescent point on the PCB 21 through pins 20, to achieve better electromagnetic shielding effect.

In addition, this application further provides a power converter. The power converter includes any one of the foregoing package structures and a housing, and the package structure is located in accommodation space enclosed by the housing 24. Specifically, FIG. 5a is a cross-sectional diagram of a power converter according to this application. As shown in FIG. 5a, the package structure is connected to the quiescent point on the PCB 21 through the pins 20, to enhance electromagnetic shielding effect of the package structure. In addition, a second metal layer 15 of the package structure may be further bonded to the housing 24 by using a material such as thermally conductive silicone grease or gel, to enhance heat dissipation. The housing 24 and the PCB 21 may be fastened through fasteners such as screws 25, pins, rivets, or spring clamps. The package structure in FIG. 5a is the same as the package structure shown in FIG. 3a, and details are not described herein again.

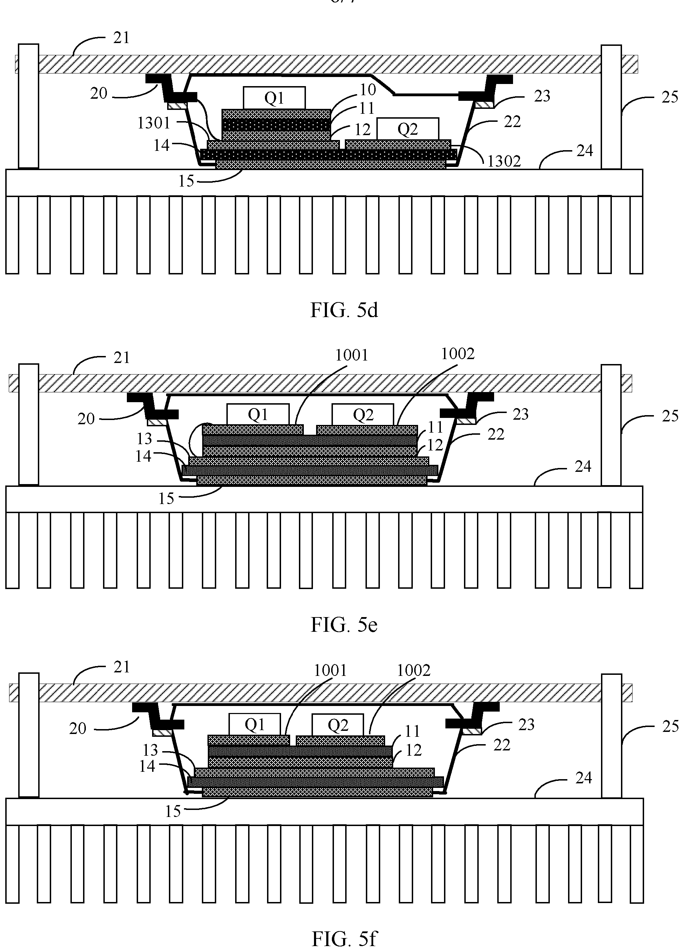

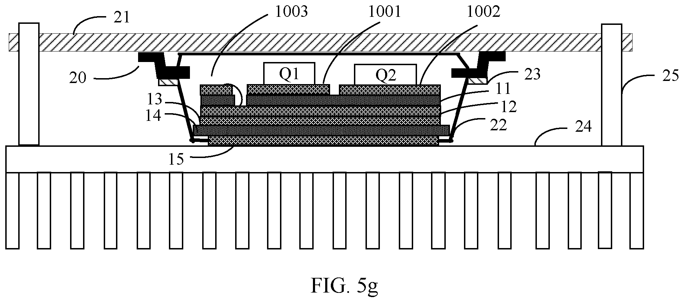

Similarly, FIG. 5b to FIG. 5g are cross-sectional diagrams of six other power converters according to this application. A difference between power converters shown in FIG. 5b, FIG. 5c, and FIG. 5d and the power converter shown in FIG. 5a lies only in that package structures are different. A package structure in FIG. 5b is the same as the package structure shown in FIG. 3b, a package structure in FIG. 5c is the same as the package structure shown in FIG. 3c, a package structure in FIG. 5d is the same as the package structure shown in FIG. 3d, a package structure in FIG. 5e is the same as a package structure shown in FIG. 3e, a package structure in FIG. 5f is the same as a package structure shown in FIG. 3f, and a package structure in FIG. 5g is the same as a package structure shown in FIG. 3g. Details are not described herein again.

In an implementation, the heat dissipation structure of the power converter is connected to the housing 24, to avoid that a medium with a low thermal conductivity coefficient, such as air, exists between the heat dissipation structure and the housing 24 to reduce heat dissipation efficiency of the power converter. Specifically, the second metal layer 15 in the heat dissipation structure may be connected to the housing 24 by using a medium such as thermally conductive silicone grease or gel.

In conclusion, the power converter provided in this application has a simple structure, low production difficulty, and low material costs, has good heat dissipation, safety regulation, and electromagnetic shielding functions, and can adapt to a working requirement of a high-power photovoltaic optimizer.

Finally, it should be noted that, in this application, the photovoltaic optimizer is merely used as an example for description. In actual application, the heat dissipation structure provided in this application may be further used in another power conversion device. This is not limited in this application.

The objectives, technical solutions, and benefits of the present invention are further described in detail in the foregoing specific implementations. It should be understood that the foregoing descriptions are merely specific implementations of the present invention, but are not intended to limit the protection scope of the present invention. Any modification, equivalent replacement, or improvement made based on the technical solutions of the present invention shall fall within the protection scope of the present invention.

## Claims

1. A power converter, wherein the power converter comprises a heat dissipation structure and a housing, wherein
the heat dissipation structure is disposed in space enclosed by the housing;
the heat dissipation structure comprises a package structure and a printed circuit board PCB; the package structure comprises: a first substrate, a second substrate, a package body, a plurality of pins, and at least one first die; and the package structure is connected to the PCB through the plurality of pins;
the first substrate, the second substrate, and the first die are plastically packaged in the package body;
the first substrate comprises a first routing layer, a first insulation layer, and a first metal layer that are sequentially stacked;
the second substrate comprises a second routing layer, a second insulation layer, and a second metal layer that are sequentially stacked;
the first metal layer is disposed on a surface that is of the second routing layer and that is away from the second metal layer;
the first metal layer is electrically connected to the second routing layer, and at least one of the first metal layer and the second routing layer is electrically connected to a quiescent point; and
the at least one first die is disposed on a surface that is of the first routing layer and that is away from the first metal layer, and a contact point between the at least one first die and the first routing layer is a moving point.

2. The power converter according to claim 1, wherein all the plurality of pins are fastened to the first routing layer; or all the plurality of pins are fastened to the second routing layer; or a part of the plurality of pins are fastened to the first routing layer, and the other part of the plurality of pins are fastened to the second routing layer; and a pin that is of the plurality of pins and that is electrically connected to the first metal layer is electrically connected to the quiescent point.

3. The power converter according to claim 1 or 2, wherein the second routing layer is divided into a first part and a second part, the first part and the second part are disposed at an interval, and the first part is in contact with a surface that is of the first metal layer and that is away from the first routing layer; and
at least one second die is disposed on a surface that is of the second part and that is away from the second metal, and a contact point between the at least one second die and the second part is a quiescent point.

4. The power converter according to any one of claims 1 to 3, wherein the plurality of pins are fastened to a side surface of the package structure, the side surface extends in a stacking direction of the first substrate and the second substrate, and the pin that is of the plurality of pins and that is electrically connected to the first metal layer is electrically connected to a quiescent point of the PCB.

5. The power converter according to any one of claims 1 to 4, wherein in the stacking direction of the first substrate and the second substrate, a projection of the first substrate is located within a contour range of a projection of the second substrate.

6. The power converter according to any one of claims 1 to 5, wherein in the stacking direction of the first substrate and the second substrate, a projection of the second routing layer and a projection of the second metal layer are located within a contour range of a projection of the second insulation layer.

7. The power converter according to any one of claims 1 to 6, wherein in the stacking direction of the first substrate and the second substrate, a projection of the first routing layer and a projection of the first metal layer coincide with a projection of the first insulation layer; or a projection of the first routing layer and a projection of the first metal layer are located within a contour range of a projection of the first insulation layer.

8. The power converter according to any one of claims 3 to 7, wherein an amount of heat generated by the at least one first die is less than an amount of heat generated by the at least one second die.

9. The power converter according to any one of claims 3 to 8, wherein a thickness of the package structure in a vertical direction of the first part is greater than a thickness of the package structure in a vertical direction of the second part.

10. The power converter according to any one of claims 1 to 9, wherein the first metal layer and the second metal layer are made of aluminum, silver, copper, or alloy, and the first insulation layer is made of a polymer or ceramic.

11. A package structure, wherein the package structure comprises: a first substrate, a second substrate, a package body, a plurality of pins, and at least one first die, wherein
the first substrate, the second substrate, and the first die are plastically packaged in the package body;
the first substrate is connected to the second substrate;
the first substrate comprises a first routing layer, a first insulation layer, and a first metal layer that are sequentially stacked;
the second substrate comprises a second routing layer, a second insulation layer, and a second metal layer that are sequentially stacked;
the first metal layer is disposed on a surface that is of the second routing layer and that is away from the second metal layer;
the first metal layer is electrically connected to the second routing layer, and at least one of the first metal layer and the second routing layer is electrically connected to a quiescent point; and
the at least one die is disposed on a surface that is of the first routing layer and that is away from the first metal layer, and a contact point between the at least one first die and the first routing layer is a moving point.

12. The package structure according to claim 11, wherein all the plurality of pins are fastened to the first routing layer; or all the plurality of pins are fastened to the second routing layer; or a part of the plurality of pins are fastened to the first routing layer, and the other part of the plurality of pins are fastened to the second routing layer; and a pin that is of the plurality of pins and that is electrically connected to the first metal layer is electrically connected to the quiescent point.

13. The package structure according to claim 11 or 12, wherein the second routing layer is divided into a first part and a second part, the first part and the second part are disposed at an interval, and the first part is in contact with a surface that is of the first metal layer and that is away from the first routing layer; and
at least one second die is disposed on a surface that is of the second part and that is away from the second metal, and a contact point between the at least one second die and the second part is a quiescent point.

14. The package structure according to any one of claims 11 to 13, wherein the plurality of pins are disposed on a side surface of the package structure, the side surface extends in a stacking direction of the first substrate and the second substrate, and the pin that is of the plurality of pins and that is electrically connected to the first metal layer is electrically connected to an external quiescent point of the package structure.

15. The package structure according to any one of claims 11 to 14, wherein in the stacking direction of the first substrate and the second substrate, a projection of the first substrate is located within a contour range of a projection of the second substrate.

16. The package structure according to any one of claims 11 to 15, wherein in the stacking direction of the first substrate and the second substrate, a projection of the second routing layer and a projection of the second metal layer are located within a contour range of a projection of the second insulation layer.

17. The package structure according to any one of claims 11 to 16, wherein in the stacking direction of the first substrate and the second substrate, a projection of the first routing layer and a projection of the first metal layer coincide with a projection of the first insulation layer; or a projection of the first routing layer and a projection of the first metal layer are located within a contour range of a projection of the first insulation layer.

18. The package structure according to any one of claims 13 to 17, wherein an amount of heat generated by the at least one first die is less than an amount of heat generated by the at least one second die.

19. The package structure according to any one of claims 13 to 18, wherein a thickness of the package structure in a vertical direction of the first part of the second routing layer is greater than a thickness of the package structure in a vertical direction of the second part of the second routing layer.
